# EUROPEAN PATENT APPLICATION

(11) **EP 1 308 995 A2**
(43) Date of publication of application: **07.05.2003**
(21) Application number: 02102513.5
(22) Date of filing: 31.10.2002
(51) Int. Cl.: H01L 21/314

(54) **Semiconductor Device Having A Dielectric Layer With A Uniform Nitrogen Profile**

(30) Priority: 31.10.2001 US 1338
(71) Applicant: Texas Instruments Incorporated, Dallas, Texas 75251 (US)
(72) Inventor: Hu, Jerry, Plano, TX 75023-1943 (US); Nicollian, Paul E., 75206-3078, Dallas (US); Eason, Kwame N., 94303-2744, Palo Alto (US); Khamankar, Rejesh, Irving, TX 75039-6076 (US); Rodder, Mark S., University Park, TX 75070-4762 (US); Hattangady, Sunil, 75070-4762, McKinney (US)
(74) Representative: Holt, Michael

(57) **Abstract**

A method for manufacturing a semiconductor device includes forming a first layer (12) adjacent a semiconductor substrate (11). The first layer (12) may comprise oxygen. The first layer may be subjected to a material (14) comprising nitrogen to form a second layer. The second layer may be oxidized to form a dielectric layer which may have a relatively uniform nitrogen profile. Rapid thermal oxidation may be used to form the dielectric layer. The dielectric layer may have a physical thickness greater than a physical thickness of the second layer.

## Description

### TECHNICAL FIELD OF THE INVENTION

This invention relates generally to semiconductor devices and, more specifically, to a semiconductor device having a dielectric layer with a generally uniform nitrogen profile, and a method for manufacture of same.

### BACKGROUND OF THE INVENTION

The demand for semiconductor devices to be made smaller is ever present because size reduction typically increases speed and decreases power consumption. The scaling of the devices in the lateral dimension requires vertical scaling as well so as to achieve adequate device performance. This vertical scaling requires the physical thickness of the gate dielectric to be reduced so as to provide the required device performance. However, thinning of the gate dielectric provides a smaller barrier to dopant diffusion and defect generation through the underlying dielectric layer and may result in devices with diminished electrical performance and reliability.

One means of reducing these problems is to form a dielectric layer by subjecting an oxide layer of a semiconductor substrate to a nitrogen-containing plasma, so that the nitrogen is either incorporated into the oxide layer or forms a nitride layer at the surface of the substrate. This method produces a dielectric layer with the beneficial barrier properties of a nitride film while having the beneficial electrical properties of an oxide film and enables a manufacturer to produce a semiconductor device with a dielectric layer having an increased physical thickness without reducing its electrical thickness, or capacitance.

This process can produce a dielectric layer having a portion with a high concentration of nitrogen atoms and another portion with a significantly lower concentration of nitrogen atoms.

### SUMMARY OF THE INVENTION

The present invention provides an apparatus and a method for manufacture of a semiconductor device having an improved dielectric layer that substantially eliminates or reduces at least some of the disadvantages and problems associated with the previous systems and methods.

In accordance with a particular embodiment of the present invention, a method of manufacturing a semiconductor device includes forming a first layer adjacent a semiconductor substrate. The first layer may comprise oxygen. The first layer is subjected to a material comprising nitrogen to form a second layer. The material comprising nitrogen may be a nitrogen plasma. The second layer may be oxidized to form a dielectric layer which may have a relatively uniform nitrogen profile. The dielectric layer may have a physical thickness greater than a physical thickness of the second layer. The physical thickness of the dielectric layer may generally be between eight and twenty-nine angstroms.

In accordance with another embodiment of the invention, the first layer may have a physical thickness of approximately nineteen angstroms. The nitrogen plasma used to form the second layer may have an ion density equal to or greater than 10¹⁰ cm⁻³. Rapid thermal oxidation may be used to form the dielectric layer.

In accordance with another embodiment of the present invention, a semiconductor device is provided. The semiconductor device includes a dielectric layer with a relatively uniform nitrogen profile. The dielectric layer may be formed by subjecting a first layer of a semiconductor substrate to a material comprising nitrogen to form a second layer and thereafter oxidizing the second layer. The first layer may have a physical thickness generally between six and twenty-six angstroms. Oxidizing the second layer may comprise subjecting the second layer to rapid thermal oxidation.

Technical advantages of particular embodiments of the present invention include a semiconductor device with a relatively uniform nitrogen profile that reduces the rate of bulk trap, or defect, generation through the dielectric layer when the semiconductor device is in use. Accordingly, the lifespan and overall reliability of the semiconductor device is increased.

Other technical advantages will be readily apparent to one skilled in the art from the following figures, descriptions and claims. Moreover, while specific advantages have been enumerated above, various embodiments may include all, some or none of the enumerated advantages.

### BRIEF DESCRIPTION OF THE DRAWINGS

For a more complete understanding of particular embodiments of the invention and their advantages, reference is now made to the following descriptions, taken in conjunction with the accompanying drawings, in which:
FIGURE 1 is a flow chart illustrating steps of the manufacturing process of a semiconductor device, in accordance with a particular embodiment of the present invention;
FIGURE 2 is a cross-sectional diagram illustrating a semiconductor device at one stage of a manufacturing process, in accordance with a particular embodiment of the present invention;
FIGURE 3 is a cross-sectional diagram illustrating the semiconductor device of FIGURE 2 at another stage of a manufacturing process, in accordance with a particular embodiment of the present invention;
FIGURE 4 is a cross-sectional diagram illustrating the semiconductor device of FIGURE 2 at another stage of a manufacturing process, in accordance with a particular embodiment of the present invention;
FIGURE 5 is a cross-sectional diagram illustrating the semiconductor device of FIGURE 2 at another stage of a manufacturing process, in accordance with a particular embodiment of the present invention; and
FIGURE 6 is a graph illustrating the approximate amount of oxygen and nitrogen in a dielectric layer formed in accordance with a particular embodiment of the present invention.

### DETAILED DESCRIPTION OF THE INVENTION

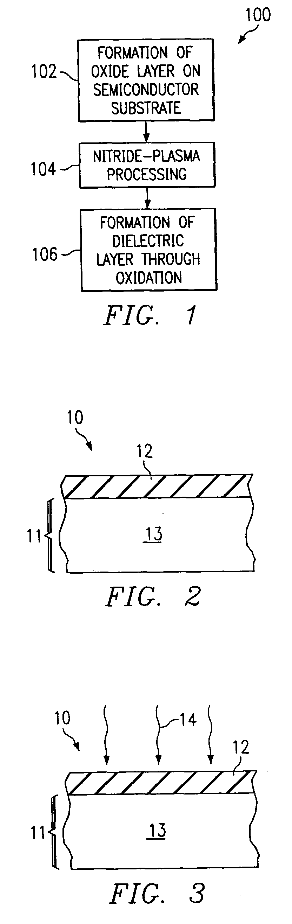

FIGURE 1 illustrates a flowchart 100 of the steps of a manufacturing process of a semiconductor device, in accordance with a particular embodiment of the present invention. Step 102 includes the formation of an oxide layer on a semiconductor substrate. Step 104 includes processing the oxide layer using a plasma containing nitrogen which results in a layer comprising both oxygen and nitrogen. Next, step 106 includes oxidizing the layer including oxygen and nitrogen to form a dielectric layer. The oxidation of step 106 may add to the physical thickness of the layer resulting from step 104. The dielectric layer formed from step 106 has a relatively uniform nitrogen profile. In other words, the concentration of nitrogen atoms remains relatively uniform throughout the dielectric layer. Having such a nitrogen profile results in a slower bulk trap, or defect, generation rate through the dielectric layer, which increases the overall reliability of the semiconductor device.

FIGURE 2 illustrates a particular stage during the manufacturing process of a semiconductor device 10, in accordance with an embodiment of the present invention. Semiconductor device 10 may be a transistor, a capacitor or any other type of suitable semiconductor device. Semiconductor device 10 includes a semiconductor substrate 11, which comprises a wafer 13. Wafer 13 is formed from a single crystalline silicon material. Semiconductor substrate 11 may comprise other suitable materials or layers without departing from the scope of the present invention. For example, semiconductor substrate 11 may include an epitaxial layer, a recrystallized semiconductor material, a polycrystalline semiconductor material or any other suitable semiconductor material.

Semiconductor device 10 includes a first layer 12 disposed at least partially upon semiconductor substrate 11. In the illustrated embodiment, first layer 12 comprises oxygen; however, first layer 12 may comprise other materials in alternative embodiments, such as silicates. First layer 12 may be formed on part of semiconductor substrate 11 by any of a variety of techniques well known to those skilled in the art. The physical thickness of first layer 12 may vary according to various embodiments. Particular embodiments of the invention may include first layer 12 with a physical thickness of generally between seven and twenty-five angstroms (for example, nineteen angstroms). First layer 12 in the illustrated embodiment has a physical thickness of twenty-three angstroms.

FIGURE 3 illustrates another stage during the manufacturing process of semiconductor device 10 of FIGURE 2. First layer 12 is subjected to a material 14 comprising nitrogen. This process may be performed by any of a variety of techniques well known to those skilled in the art, such as ion implantation or plasma nitridation. Material 14 may be any suitable substance containing nitrogen, such as N₂, NH₃, NO, N₂O or a mixture thereof. In the illustrated embodiment, material 14 is a nitrogen plasma, which may have a high density, such as between 10¹⁰ and 10¹² cm⁻³. Wafer 13 may be unbiased in which case the ionized substances are accelerated by the plasma potential and then implanted into first layer 12. A bias voltage may be applied to wafer 13 to further accelerate the ions from the plasma and implant them deeper into first layer 12. Either a DC or an RF bias voltage can be used to bias the wafer. The process may be performed under any suitable process conditions, such as a plasma power generally between 200W and 2000W (for example 800W or 500W), nitrogen on the order of 1 to 100 sccm, process pressure on the order of 1 to 50 mTorr, temperature around 70 to 900K, wafer bias on the order of 0 to 50 volts, and an exposure duration of between 1 and 60 seconds.

Many variables and techniques may be controlled, incorporated and/or modified to produce different effects and results in the methods and steps described herein, including wafer bias, duration of exposure to plasma, plasma power, and use of a post nitridation anneal. For example, such variables may be controlled, incorporated and/or modified to vary the depth which the nitrogen is driven into first layer 12, or underlying substrate 11, and/or in order to repair any damage. More specifically, changes to such variables may be used to increase or decrease the depth which the nitrogen is driven into first layer 12. In addition, a low density plasma or a high density plasma may be used depending on the amount of nitrogen drive-in desired.

In the illustrated embodiment of FIGURE 3, Remote Plasma Nitridation (RPN) is used to subject a first layer to a nitrogen plasma. Specific techniques to accomplish this are described in U.S. Patent No. 6,136,654, issued to Kraft, et al. ("'654"). The '654 Patent is hereby incorporated by reference, for all purposes. The methods, steps and processing techniques described in Kraft may be incorporated into various embodiments of the present invention.

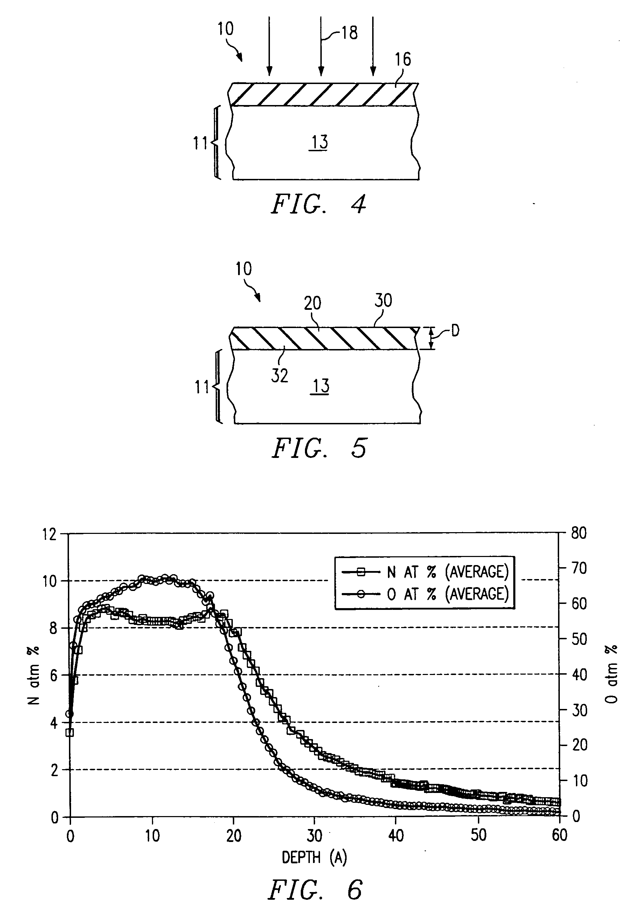

FIGURE 4 illustrates another stage during the manufacturing process of semiconductor device 10 of FIGURE 3. Layer 16, which comprises nitrogen and oxygen, is formed from subjecting first layer 12 of FIGURE 3 to material 14. Layer 16 may have varying amounts of silicon, nitrogen and oxygen throughout. Semiconductor device 10 is then put through an oxidation process 18 whereby layer 16 is oxidized. The oxidation of layer 16 may increase the physical thickness of layer 16 by a desired amount, forming a dielectric layer 20 (shown in FIGURE 5). For example, two to three angstroms may be added to the physical thickness of layer 16 through oxidation process 18 to form the dielectric layer. Moreover, during the oxidation process, the nitrogen profile of the resulting dielectric layer is controlled.

The oxidation process used may be any process suitable to form a dielectric layer having a desired physical thickness, for example, twenty-six angstroms, and a relatively uniform nitrogen profile. Using an oxidation process to achieve a desired physical thickness enables a manufacturer of a semiconductor device to produce a dielectric layer according to predetermined physical thickness specifications. A dielectric layer with a relatively uniform nitrogen profile generally means that the concentration of nitrogen atoms is relatively constant (e.g. within 15% difference) at different depths throughout the dielectric layer.

The oxidation process may be performed by any of a variety of techniques well know to those skilled in the art. For example, rapid thermal oxidation ("RTO") may be used to oxidize layer 16. RTO is a rapid thermal process conducted in an atmosphere comprising oxygen. Various process conditions can be used during RTO; however, RTO process conditions may include a temperature generally in the range of 700C to 1100C (for example, 1000C), for a period of time generally in the range of 5 seconds to 90 seconds (for example, 15 or 60 seconds) and an ambient comprising N₂O, O₂ and N₂, and any combination of one or all of those (such as 20% O₂ and 80% N₂) . Processes other than RTO may be used to oxidize layer to achieve a desired physical thickness and relatively uniform nitrogen profile of the resulting dielectric layer. For example, fast thermal process (FTP) oxidation and in-situ steam generation (ISSG) oxidation may be suitable.

FIGURE 5 illustrates another stage during the manufacturing process of semiconductor device 10 of FIGURE 4, showing dielectric layer 20 which is formed through the oxidation of layer 16. Dielectric layer 20 comprises nitrogen and oxygen. The physical thickness of dielectric layer 20 may vary according to various embodiments. For example, particular embodiments of the invention may include a dielectric layer 20 with a physical thickness of generally between nine and twenty-eight angstroms. Dielectric layer 20 has a relatively uniform nitrogen profile resulting from the previous nitridation and oxidation processes, leading to a slower defect generation rate through dielectric layer 20.

Semiconductor device 10 of FIGURE 5 includes dielectric layer 20 which has a generally uniform nitrogen profile. In general, there are at least two measurements of interest with regard to the nitrogen atom concentration throughout a depth D of dielectric layer 20. One such measurement is the difference between the nitrogen atom concentration at the surface 30 of dielectric layer 20, and the nitrogen atom concentration at interface 32 of the dielectric layer. Interface 32 means a point within the dielectric layer where the oxygen atom concentration drops to 90% of the peak oxygen atom concentration within the dielectric layer. Another such measurement is the difference between the nitrogen atom concentrations taken at any two points along the depth D of the dielectric layer 20, anywhere between surface 30 and interface 32. For the purposes of this specification, a relatively uniform nitrogen atom concentration means that the difference in nitrogen atom concentrations at any two points along the depth D of dielectric layer 20 is between 0% and 25% of one another (percent variation of between 0% and 25%), for example, within 12% of one another.

Similarly, a dielectric layer having a nitrogen atom concentration throughout the dielectric layer which varies by less than 8.5% is considered a relatively uniform nitrogen profile, as would a dielectric layer with a nitrogen atom concentration which does not vary by more than approximately six percent throughout the dielectric layer. Having a dielectric layer of a semiconductor device with a relatively uniform nitrogen profile decreases the defect generation rate through the dielectric layer, as a dielectric layer with a large nitrogen atom concentration disparity within the layer causes defects to form quicker within the layer. A decreased defect generation rate leads to an increase in the lifespan and overall reliability of the semiconductor device.

FIGURE 6 is a graph illustrating the level of oxygen and nitrogen in dielectric layer 20, formed using an embodiment of the present invention. The data illustrated is taken from a SIMS analysis of the formation of a dielectric layer through the nitride-plasma process of a first oxide layer followed by an oxidation process under the following conditions: the power was 2000 W, the ambient pressure was 20 mTorr, the duration was 15 seconds and the physical thickness of the first oxide layer was 22 angstroms. As illustrated, the resulting dielectric layer has a relatively uniform nitrogen profile.

FIGURE 6 illustrates the uniformity of nitrogen atom concentration of dielectric layer 20 of FIGURE 5. For example, after factoring out external "noise" detected by the measurement device, the nitrogen atom concentration throughout the depth D of dielectric layer 20 may be determined. For example, the nitrogen atom concentration at the surface 30 is approximately 8.9%. The nitrogen atom concentration at the interface 32 is approximately 8.8%. Therefore, the difference between the nitrogen atom concentrations at the surface 30 and interface 32 are within approximately 1.1% of one another.

Across the depth of dielectric layer 20, the nitrogen atom concentration ranges from approximately 8.9% to approximately 8.1%. Therefore, across the depth D of dielectric layer 20, the nitrogen atom concentration does not vary by more than approximately 9%.

Although particular configurations have been illustrated for semiconductor device 10, semiconductor device 10 may have a variety of other configurations in various embodiments. For example, along with the formation of dielectric layer 20, further structures familiar to those skilled in the art may be added to semiconductor device 10 during the manufacturing process before, during and/or after the formation of dielectric layer 20. If semiconductor device 10 is a transistor, a conductive gate structure may be added at least partially upon dielectric layer 20. Furthermore, source and implant regions may be formed within semiconductor substrate 11. A variety of other configurations will be readily suggested by those skilled in the art.

The teachings of the present invention achieve a semiconductor device having a highly reliable thin gate dielectric. This highly reliable thin gate dielectric has the advantages of: (i) a relatively thick physical thickness having a high dielectric constant similar to a much thinner electrical device; and (ii) a nitrogen profile across which is relatively uniform across the gate dielectric to reduce trap generation. To achieve this, the method begins by growing a very physically thin (relatively) starting layer (for example, an oxide such as a pure oxide, NO, N₂O annealed oxides, etc.). A process such as Remote Plasma Nitridation (RPN) is then used to introduce nitrogen to the physically thin first layer. RPN is beneficial to achieving a relatively thick device having a high dielectric constant, by introducing a significant amount of nitrogen without significant mobility degradation. In a particular embodiment, RPN is used to subject an oxide layer to a nitrogen containing substance for example, as described above with regard to FIGURE 3. While it is difficult to achieve a uniform nitrogen profile on a thick oxide layer, RPN helps achieve a relatively uniform nitrogen profile on a thinner oxide layer, for example the first layer of FIGURE 2.

In order to increase the physical thickness of the semiconductor device after conducting a nitride process such as RPN on a thin oxide layer, an appropriate process may be used to re-oxidize the oxide, to increase the physical thickness of the semiconductor device, while maintaining the targeted electrical characteristics (electrical thickness, or capacitance, dielectric constant, etc.). In the illustrated embodiment, RTO is used to re-oxidize the oxide, while maintaining the relatively uniform nitrogen profile. FIGURE 6 illustrates an example of the nitrogen profile that can be achieved, using the techniques described herein.

Other embodiments of the present invention may not require the oxidation process (i.e. RTO) that is used to add to the physical thickness of the first layer after subjecting the layer to a nitrogen plasma. In this case, a first layer, such as an oxide layer, having a certain physical thickness (for example, between nine and twenty-four angstroms) is formed on the semiconductor substrate. Next, the first layer is subjected to a material comprising nitrogen using the techniques described above (i.e., RPN) while achieving a relatively uniform nitrogen profile to form a dielectric layer having such a profile. For example, the difference in nitrogen atom concentrations at any two points along the depth of the resulting dielectric layer would be between 0% and 15% of one another (for example, less than 10% of one another). In these embodiments that do not use an oxidation process after subjecting the first layer to a nitride, concentrations of nitrogen atoms through the depth of the resulting dielectric layer can be achieved which are identical to the concentrations of nitrogen atoms achieved using the techniques described above with regard to other embodiments.

Although the present invention has been described in detail, various changes and modifications may be suggested to one skilled in the art. It is intended that the present invention encompass such changes and modifications as falling within the scope of the appended claims.

## Claims

1. A semiconductor device, comprising:
a dielectric layer having a relatively uniform nitrogen profile; and
wherein the dielectric layer is formed by subjecting a first layer of a semiconductor substrate to a nitrogen plasma to form a second layer and oxidizing the second layer.

2. The semiconductor device of Claim 1, wherein the relatively uniform nitrogen profile comprises a difference between a first nitrogen atom concentration at a surface of the dielectric layer and a second nitrogen atom concentration at an interface between the dielectric layer and the semiconductor substrate, of between 0.5% and 3% of the first nitrogen atom concentration.

3. The semiconductor device of Claim 1, wherein the relatively uniform nitrogen profile comprises a difference between a first nitrogen atom concentration at a surface of the dielectric layer and a second nitrogen atom concentration at an interface between the dielectric layer and the semiconductor substrate, of approximately 1.1% of the first nitrogen atom concentration.

4. The semiconductor device of Claim 1, wherein the relatively uniform nitrogen profile comprises a difference between first and second nitrogen atom concentrations measured at any two points along a depth of the dielectric layer of between 0% and 25% of the first nitrogen atom concentration.

5. The semiconductor device of Claim 1, wherein the relatively uniform nitrogen profile comprises a difference between first and second nitrogen atom concentrations measured at any two points along a depth of the dielectric layer of approximately 9% of the first nitrogen atom concentration.

6. The semiconductor device of Claim 1, wherein the dielectric layer has a concentration of nitrogen atoms less than 8.5% throughout the dielectric layer.

7. A method of manufacturing a semiconductor device, comprising:
forming a first layer adjacent a semiconductor substrate, the first layer comprising oxygen and having a physical thickness of generally between nine and twenty-four angstroms;
subjecting the first layer to a plasma to form a dielectric layer, wherein the plasma comprises nitrogen; and
the dielectric layer having a relatively uniform nitrogen profile.

8. The method of Claim 7, wherein the relatively uniform nitrogen profile comprises a difference between first and second nitrogen atom concentrations measured at any two points along a depth of the dielectric layer of between 0% and 25% of the first nitrogen atom concentration.

9. The method of Claim 7, wherein the relatively uniform nitrogen profile comprises a difference between first and second nitrogen atom concentrations measured at any two points along a depth of the dielectric layer of approximately 9% of the first nitrogen atom concentration.
